# EUROPEAN PATENT SPECIFICATION

(11) **EP 2 026 487 B1**
(45) Date of publication and mention of the grant of the patent: **30.07.2014**
(21) Application number: 08721430.0
(22) Date of filing: 06.03.2008
(51) Int. Cl.: H04J 11/00, H03F 1/32, H04B 1/04, H04J 1/00, H04L 27/36, H04L 27/26, H03F 1/02

(54) **OFDM MODULATED WAVE OUTPUT DEVICE AND DISTORTION COMPENSATION METHOD**
EINRICHTUNG ZUR AUSGABE OFDM-MODULIERTER WELLEN UND VERFAHREN ZUR VERZERRUNGSKOMPENSATION
DISPOSITIF D'ÉMISSION D'ONDE MODULÉE PAR MULTIPLEXAGE PAR RÉPARTITION ORTHOGONALE DE LA FRÉQUENCE ET PROCÉDÉ DE COMPENSATION DE DISTORSION

(30) Priority: 08.03.2007 JP 2007058565
(43) Date of publication of application: 18.02.2009
(73) Proprietor: NEC Corporation, Minato-ku Tokyo 108-8001 (JP)
(72) Inventor: FUJIMOTO, Yoshinori, Tokyo 108-8001 (JP)
(74) Representative: Stork Bamberger
(86) International application number: PCT/JP2008/054010
(87) International publication number: WO 2008/111471

(56) References cited:
- JP-A- 03 285 404
- JP-A- 05 259 765
- JP-A- 10 209 770
- JP-A- 2001 244 828
- JP-A- 2005 117 315
- JP-A- 2005 198 109
- JP-A- 2005 244 430
- US-A1- 2004 061 555
- US-A1- 2004 252 785
- US-A1- 2006 046 666
- FRIESE M.: 'On the degradation of OFDM-signals fue to peak-clipping in optimally predistorted power amplifiers' GOBAL TELECOMMUNICATIONS CONFERENCE, 1998. GLOBECOM 98. THE BRIDGE TO GLOBAL INTEGRATION. IEEE vol. 2, 12 November 1998, pages 939 - 944, XP000825888

## Description

### FIELD OF THE INVENTION

The present invention relates to an OFDM-modulated-wave output unit and a distortion compensating method and, more particularly, to an OFDM-modulated-wave output unit that generates an OFDM-modulated wave and a distortion compensating method used in such an OFDM-modulated-wave output unit

### BACKGROUND OF THE INVENTION

In an OFDM (orthogonal frequency division multiplex) technique, the frequency spectrum of the signal used therein is close to a rectangle, whereby a higher utilization efficiency of the frequency is obtained. In addition, the OFDM technique has a significant resistance against a delayed wave because the symbol length can be made larger than the single carrier, and addition of a guard interval, if employed, renders the OFDM technique stronger in a multi-path environment. On the other hand, in the OFDM technique, which performs multi-carrier transmission wherein a larger number of subcarriers exist, the OFDM signal has a larger peak power if the subcarriers have respective peaks overlapping each other. If such an OFDM signal is input to a power amplifier having a non-linear characteristic, there occurs degradation of characteristics such as degradation of transmission characteristic and increase in the out-of-band radiation.

As countermeasures for dealing with the nonlinear distortion in the OFDM technique, there are known techniques including a predistortion technique (described in Patent Publication-1 and Literature-1), a LCP-COFDM (linearized constant peak-power coded OFDM) technique (described in Literature-2), a partial transmit sequence (PTS) technique (described in Literature-3), an LCP-COFDM/partial transmit sequence combination technique, and a linearity improvement technique upon generation of peak power (described in Patent Publication-2). The outline of these techniques will be described hereinafter.

The predistortion technique (Literature-1) adds an inverted characteristic of the input-output characteristic of a power amplifier to the input signal of the power amplifier, to cancel the nonlinearity of the input-output characteristic of the power amplifier. The output signal of the power amplifier is a signal amplified by an amplifier having a sufficient linearity, whereby the nonlinear distortion is cancelled and the out-of-band radiation is improved. The LCP-COFDM technique (Literature-2) is used in conjunction with a predistortion technique, and suppresses the OFDM signal below the saturated power level before applying the predistortion therein.

The partial transmit sequence technique (Literature-3) partitions the signal transmitted by the subcarriers of the OFDM into a plurality of sub-blocks, performs inverse Fourier transform of each of the sub-blocks, and thereafter shifts the phase of each sub-block along the time axis in an amount of phase weighting so that the peak power assumes a minimum, thereby reducing the peak power of the OFDM signal. This phase weighting is transmitted to the receiving side as a side information, which is used for demodulation in the receiving side.

The LCP-COFDM/partial transmit sequence combination technique (Literature-4) is a technique that combines the LCP-COFDM technique and the partial transmit sequence technique. The linearity improvement technique upon generation of peak power (Patent Publication-2) is such that a high voltage or large current is temporarily applied to a power amplifier when a peak power is generated, to thereby improve the linearity thereof. This technique improves the transmission characteristic and out-of-band characteristic of the OFDM signal so long as the maximum rating of the components in a high-power power amplifier is not exceeded and an adverse influence is not incurred.

### List of Literatures and Publications

Literature-1: K. Wesolowski and J. Pochmara, "Efficient algorithm for adjustment of adaptive predistorter in OFDM transmitter", IEEE VTS-Fall VTC 2000, vol.5, pp.2491-2496, Sept. 2000.
Literature-2: S. Uwano and Y Matsumoto, and M. Mizoguchi, "Linearized constant peak-power coded OFDM transmission for broadband wireless access systems", Proc. IEEE PIMRC'99, pp.358-362, Sept. 1999.
Literature-3: Seog Geun Kang, Jeong Goo Kim and Eon Kyeong Jo, "A novel subblock partition scheme for partial transmit sequence OFDM", IEEE Transactions on Broadcasting, Vol.45, Issue: 3, pp. 333-338, Sep 1999.
Literature-4: Takaaki Horiuchi, Yo Iso, Tomoaki Otsuki, Iwao Sasase, "Characteristic evaluation of OFDM nonlinear distortion compensation technique using predistortion and partial transmit sequence", Singakuron (B) Vol. J85-B, No. 11, pp. 1865-1873, Nov, 2002.
Patent Publication-1: JP-2000-252946A
Patent Publication-2: JP-2001-292034A

In the predistortion technique, it is impossible to compensate a peak power equal to or above the saturation power of the power amplifier. In the LCP-COFDM technique, the output modulated wave is susceptible to noise upon generation of a higher peak power because the signal power is controlled to a lower level. The partial transmit sequence technique has a limit on the peak power that is capable of being reduced by the phase weighting although the out-of-band distortion can be reduced by reducing the peak power, and thus it is not possible to suppress the peak power in the absolute value thereof.

In the LCP-COFDM/partial transmit sequence technique, there is a defect that transmission of side information is needed as well although the characteristic improvements by both the techniques can be achieved. In the linearity improvement technique upon generation of the peak power, although the linearity can be improved by temporarily applying a higher voltage or larger current, the linearity improvement of the power amplifier thus achieved is accompanied by occurring of changes in the small signal gain, delay time characteristic, non-linearity characteristic (AM(amplitude modulation)-AM characteristic, or AM-PM(phase modulation) characteristic) of the amplifier, thereby incurring quality degradation of the signal when handling a higher peak power.

### SUMMARY OF THE INVENTION

It is an object of the present invention to provide an OFDM-modulated-wave output unit and a distortion compensating method which are capable of compensating in a short delay time a distortion generated when the OFDM-modulated wave has a peak.

The present invention provides an OFDM-modulated wave output unit that uses a predistortion technique, including: an amplitude extraction section that extracts an amplitude of an OFDM-modulated wave based on input data; a power-amplifier control section that sets a supply power of a power amplifier amplifying the OFDM-modulated wave to exceed a rated power thereof if the amplitude extracted by the amplitude extraction section is larger than a specific amplitude, thereby expanding a saturation point of the power amplifier; and a compensation-value-selection control section that determines a weighting factor in predistortion of the amplitude based on a first compensation-value data table for use in compensating a non-linear characteristic of the power amplifier upon expanding the saturation point of the power amplifier, when the power-amplifier control section expands the saturation point of the power amplifier.

The present invention provides a distortion compensating method in an OFDM transmission system using a predistortion technique, including: extracting an amplitude of an OFDM-modulated wave based on input data; setting a supply power of a power amplifier amplifying the OFDM-modulated wave to exceed a rated power thereof if the extracted amplitude is larger than a specific amplitude, thereby expanding a saturation point of the power amplifier; and determining a weighting factor in predistortion of the amplitude based on a first compensation-value data table for compensating a non-linear characteristic of the power amplifier upon expanding the saturation point of the power amplifier.

The above and other objects, features and advantages of the present invention will be more apparent from the following description, referring to the accompanying drawings.

FIG 1 is a block diagram showing the configuration of an OFDM-modulated-wave output unit according to an embodiment of the present invention.
FIG 2 is a diagram showing an example of mapping input data.
FIG 3 is a graph showing the input-output characteristic of a power amplifier and an inverted characteristic added in the predistortion.
FIG 4 is a block diagram showing the configuration during rewriting of a compensation-value data table.

### DETAILED DESCRIPTION OF THE INVENTION

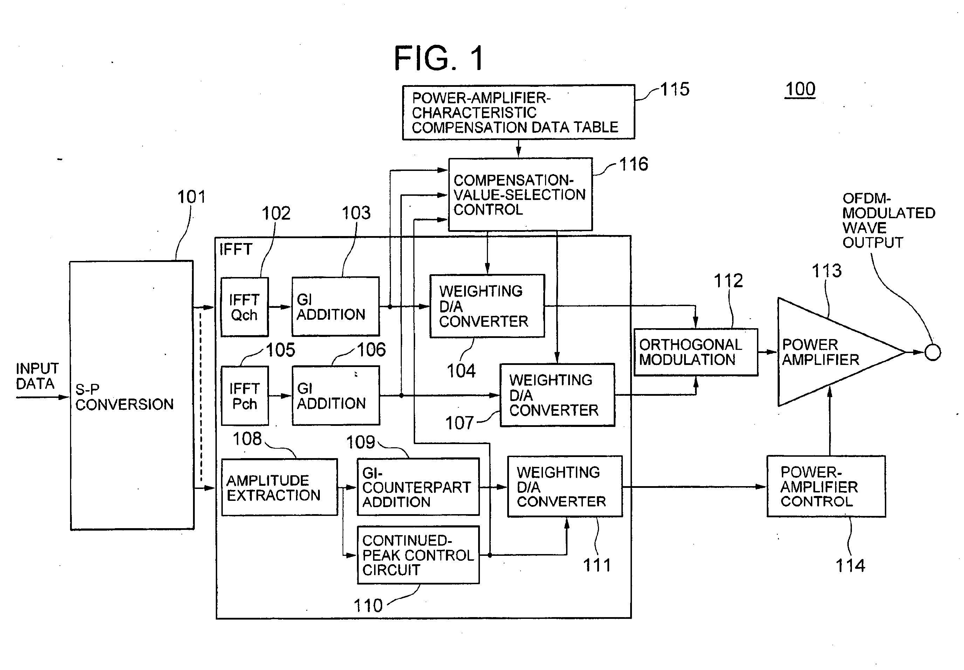

Hereafter, an exemplary embodiment of the present invention will be described in detail with reference to the accompanying drawings. FIG 1 shows the configuration of an OFDM-modulated-wave output unit according to the embodiment of the present invention. The OFDM-modulated-wave output unit 100 includes a serial/parallel conversion circuit (S-P conversion circuit) 101, IFFT circuits (inverse-fast-Fourier transform circuits) 102 and 105, a GI (guard interval) addition circuits 103 and 106, weighting D/A converters 104 and 107, a orthogonal modulation circuit 112, a power amplifier 113, an amplitude extraction circuit 108, a GI-counterpart addition circuit 109, a continued-peak control circuit 110, a weighting D/A (digital/analog) converter 111, a power-amplifier control circuit 114, a power-amplifier-characteristic compensation data table 115, and a compensation-value-selection control circuit 116.

The S-P conversion circuit 101 converts an input serial-data string into parallel data. The IFFT(Qch) 102 and IFFT(Pch) 105 receive the input data converted into the parallel data, and perform inverse fast Fourier transform with respect to the real component and imaginary component, respectively, thereof. The output of the IFFT(Qch) 102, to which a guard interval is added in the GI-addition circuit 103, is input to the quadrature modulation circuit 112 via the weighting D/A converter 104. The output of IFFT(Pch) 105, to which a guard interval is added in the GI-addition circuit 106, is input to the quadrature modulation circuit 112 via the weighting D/A converter 107. The quadrature modulation circuit 112 performs quadrature modulation of both the signals. The power amplifier 113 amplifies and delivers the output of the quadrature modulation circuit 112. The operations up to this operation are similar to those in a typical OFDM-modulated-wave generation scheme.

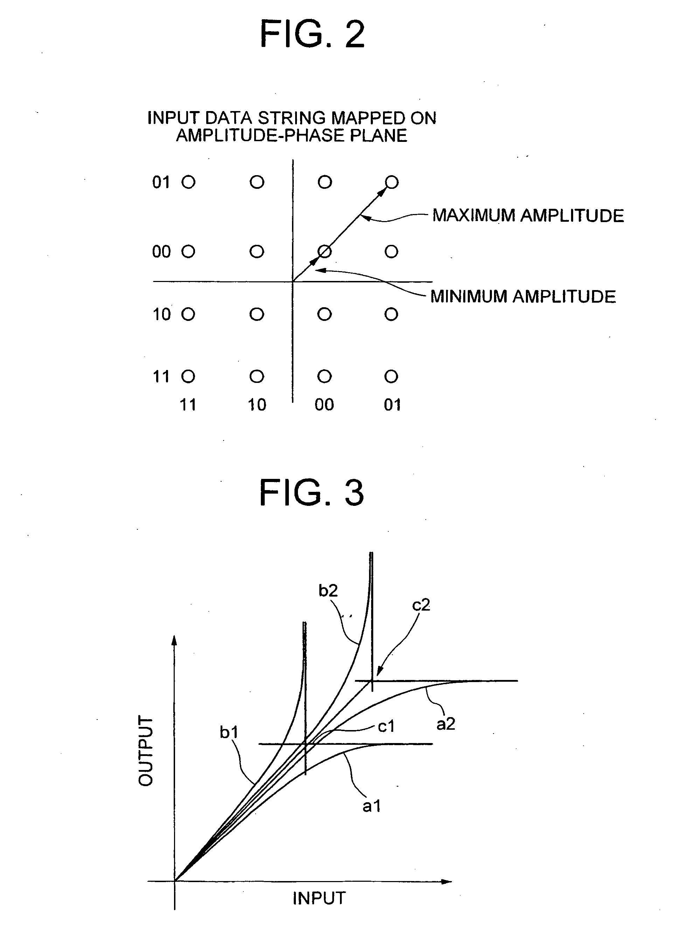

The amplitude extraction circuit 108 extracts the amplitude of the combination of input data. In the OFDM modulation, the parallel-converted input data is grouped based on the subcarriers, and is subjected to a amplitude-phase (frequency) mapping for each of the subcarriers. FIG 2 shows the input data string mapped on the amplitude-phase plane. This example is directed to 16-QAM. The mapped signal is converted into a time signal from the signal on the frequency axis by the inverse fast Fourier transform. An OFDM-modulated wave is obtained by applying quadrature modulation by using resultant time signal. In the OFDM modulation, when the data train is mapped, the amplitude-phase state of the modulated wave of each subcarrier can be judged. The amplitude extraction circuit 108 performs vectorial composition of the subcarriers by using the amplitude-phase of each subcarrier, and takes out the absolute value of the amplitude component therefrom to thereby extract the amplitude component of the OFDM-modulated wave.

The amplitude extracted by the amplitude extraction circuit 108 is added by an amplitude corresponding to the guard interval in the GI-counterpart addition circuit 109, and input to weighting D/A converter 111. The weighting D/A converter 111 performs weighting to the amplitude value, and outputs the value according to the input amplitude value. The weighting factor applied to the input amplitude is stored in a storage device in the form of a function, a table etc. Based on the output of the weighting D/A converter 111, the power-amplifier control circuit 114 controls the supply voltage or current of the power amplifier 113, to control the power of the power-amplifier control circuit 114. If the amplitude extracted by the amplitude extraction circuit 108 is larger than a specific amplitude, the power-amplifier control circuit 114 increases the electric power supplied to the power amplifier 113 up to a power exceeding the rated power based on the output of the weighting D/A converter 111, to expand the saturation point of the power amplifier 113. The power-amplifier control circuit 114 sets the supply voltage in the power amplifier 113 at 5V for example, if the amplitude extracted by the amplitude extraction circuit 108 is zero to 5V, and sets the supply voltage in the power amplifier 113 at 12V if the amplitude is 10V. The power-amplifier control circuit 114 sets the supply voltage in the power amplifier 113 at 6V, if the amplitude is 6V, and sets the supply voltage in the power amplifier 113 at 10V if the amplitude is 9V.

FIG 3 shows the input-output characteristic of the power amplifier 113. The output of the power amplifier 113 is nonlinear with respect to the input, as shown by curve al. In order to compensate this, predistortion is performed, as shown by curve b1, by providing an inverted characteristic of the input-output characteristic of the power amplifier 113 at the preceding stage of the power amplifier 113. More specifically, using the weighting D/A converters 104 and 107, the inverted characteristic of the power amplifier 113 is added to the output of the IFFT(Qch) circuit 102 and IFFT(Pch) circuit 105 to perform the predistortion. The inverted characteristic added by the weighting D/A converters 104 and 107 is stored in the power-amplifier-characteristic compensation data table 115. The compensation-value-selection control circuit 116 determines the weighting factor of the weighting D/A converters 104 and 107 with reference to the power-amplifier-characteristic compensation data table 115 based on the output value of the IFFT(Qch) 102 and the output value of the IFFT(Pch) 105.

Here, if the power of the power amplifier 113 is increased by the power-amplifier control circuit 114 to allow the saturation point to expand from c1 to c2, the input-and-output characteristic of the power amplifier 113 changes to curve a2 along with the expansion. In order to compensate this, other than the table for the normal state, another table which specifies the compensation value corresponding to the power supply provided upon expanding the saturation point of the power amplifier 113 is prepared beforehand in the power-amplifier-characteristic compensation data table 115. The compensation-value-selection control circuit 116 selects a table that specifies curve b2 corresponding to the inverted characteristic of the input-and-output characteristic upon allowing the saturation point to expand, if the amplitude value extracted by the amplitude extraction circuit 108 is an amplitude value that allows the saturation point of the power amplifier 113 to expand. Thereafter, with reference to the selected table, the weighting factor of the weighting D/A converters 104 and 107 is determined based on the output value of the IFFT(Qch) 102 and the output value of the IFFT(Pch) 105. Thus, the nonlinearity generated upon expanding the saturation point can be compensated.

The power amplifier 113 has a significant resistance against an instantaneous peak power within a range of the average power which does not exceed the absolute maximum rating, similarly to transmitters, such as a radar. Therefore, when the OFDM waveform assumes a maximum peak power, the power-amplifier control circuit 114 may expand the saturation point of the power amplifier 113 by increasing the supply voltage or current thereof only at this stage, without involving any problem. However, if the peak continues, the time-averaged power of the power amplifier 113 may exceed the absolute maximum rating. In the case of a continued peak, the power of the power amplifier 113 is lowered to protect the power amplifier 113.

The continued-peak control circuit 110 detects a continued peak based on the output of the amplitude extraction circuit 108, and lowers the output level of the weighting D/A converter 111 to reduce the power of the power amplifier 113, if the peak continues. The continued-peak control circuit 110 integrates the output of the amplitude extraction circuit 108, for example, and judges occurring of a continued and reduces the power of the power amplifier, if the integrated value exceeds a specific value. Thus, the situation where the time-averaged power of the power amplifier 113 exceeds the absolute maximum rating can be avoided. The rate of reduction in the power is roughly such that the AGC (automatic gain control) can track the reduction in the receiving side.

If the power of the power amplifier 113 is changed by operation of the continued-peak control circuit 110, the input-output characteristic of the power amplifier 113 is changed in accordance therewith. In order to handle this, the compensation-value-selection control circuit 116 changes the characteristic-compensation data table to be used, in accordance with the power change of the power amplifier 113. Due to the compensation-value-selection control circuit 116 selecting the table in accordance with the power of the power amplifier 113, the weighting performed in the weighting D/A converters 104 and 107 is changed, whereby linearity of the output of the power amplifier 113 is maintained.

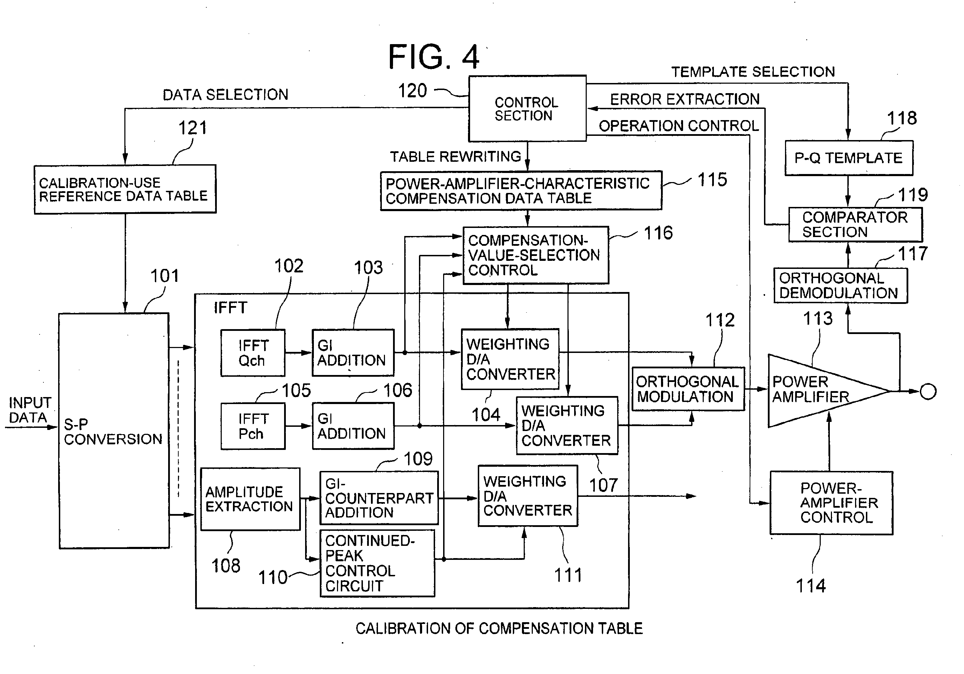

FIG 4 shows the configuration upon calibration of the compensation data table. Upon the calibration, a control section 120 sets the power of the power amplifier 113 at a power exceeding the rating thereof. The S-P conversion circuit 101 receives in this state known data from a calibration-use reference data table 121, and the weighting D/A converters 104 and 107 each output an OFDM-modulated wave corresponding to the input data. An orthogonal demodulator 117 demodulates the OFDM-modulated wave, and acquires P-signal and Q-signal. A P-Q template 118 stores therein P-signal and Q-signal corresponding to the data included in the calibration-use reference data table 121, and a comparator section 119 compares the P-signal and Q-signal obtained by the demodulation against the P-signal and Q-signal, respectively, stored in the P-Q template 118. The control section 120 extracts error information from the comparator section 119, and performs table rewriting with respect to the power-amplifier-characteristic compensation data table 115 so that the error assumes a minimum. By iteratively performing this table rewriting, the characteristic compensation data table corresponding to each power of power amplifier 113 is obtained

In the present embodiment, an amplitude value is extracted in the amplitude extraction circuit 108 from an input data string, to control the power of the power amplifier 113 depending on the extracted amplitude value. In the present embodiment, differently from the LCP-OFDM technique, the supply voltage or current is increased only when the OFDM waveform assumes a maximum peak power, to thereby expand the saturation point of the power amplifier 113. In this way, the linearity upon occurring of the peak power can be secured. When the OFDM-modulated wave does not assume the peak power, a lower power dissipation is obtained by operating in a comparatively smaller back-off. In addition, combination with the PTS (partial transmit sequence) technique, if used, provides a wider dynamic range and a lower power dissipation.

As a related art, a technique is known which extracts only an amplitude component from the P- and Q-signals converted into an analog signal, returns the same into a digital signal, and performs amplitude modulation using a power amplifier in a stepwise manner. However, in this technique, the phase modulation and amplitude modulation are performed separately from each other, which raises a serious problem in the synchronization and thus is not practical. An achievement similar to the above achievement may be possible by calculating the vectorial sum of the orthogonal P- and Q-signals after IFFT conversion thereof. However, since a delay corresponding to the time length for calculating the vectorial sum occurs, it is necessary to delay the P- and Q-signals for compensating the delay. In order to achieve a higher-speed data transmission, the absolute delay incurred by those calculations must be reduced as much as possible. If those calculations are performed in series, there is a defect that the absolute delay is increased, and thus the higher-speed transmission is impossible. In the present embodiment, calculation of the orthogonal P- and Q-signals and extraction of the amplitude are performed in parallel, thereby achieving the higher-speed data transmission.

When the power of the power amplifier 113 is changed depending on the amplitude extracted from the input data string, there occurs a phase lead or phase lag (in AM-PM conversion) due to the change of gain, because the saturation point of the power amplifier 113 is changed. For compensating this, the characteristic of the power amplifier 113 is learned beforehand, and the OFDM-modulated wave is subjected to predistortion in advance to cancel the phase/amplitude error caused by the signal for controlling the saturation point. This maintains the linearity. Although a hysteresis upon the gain change of the power amplifier 113 incurs different amounts of compensation needed for the nonlinear distortion depending on the pattern of an input data string, the OFDM-modulated-wave output unit of the present embodiment can handle such different amounts of compensation. In the present embodiment, if the peak continues, the power of the power amplifier 113 is gradually reduced by the continued-peak control circuit 110. In this way, the power amplifier 113 can be protected.

In the above embodiment, an amplitude is extracted based on the input data, and if the extracted amplitude is larger than the specific amplitude, the power of the power amplifier is set at a power exceeding the rated power, to expand the saturation point of the power amplifier. The power amplifier is operated in a relatively smaller back-off, to achieve a lower power dissipation when the OFDM-modulated wave does not assume a peak power, whereas the saturation point is expanded to maintain the linearity thereof when the OFDM-modulated wave assumes the peak power. Extraction of the amplitude is performed based on the input data. Although there is also another technique that extracts the amplitude with respect to the P- and Q-signals after performing inverse fast Fourier transform thereof, the delay time increases in this case because the inverse fast Fourier transform and amplitude extraction are performed in series. In the above embodiment, the delay time can be reduced by performing the inverse fast Fourier transform and amplitude extraction in parallel.

In the control of the power of the power amplifier in the above embodiment, the power of the power amplifier is increased in a stepwise manner depending on the extracted amplitude. This configuration can expand the saturation power of the power amplifier depending on the peak of the OFDM-modulated wave.

The above embodiment employs a configuration wherein the power-amplifier-characteristic compensation data table used upon expanding the saturation point of the power amplifier includes compensation data tables corresponding to a plurality of powers of the power amplifier, and the compensation-value-selection control circuit selects a compensation data table corresponding to the power set in the power amplifier. In this case, the linearity of the input-and-output characteristic can be maintained for each power of the power amplifier.

In the above embodiment, a digital value obtained by inverse Fourier transform of the input data, and a weighting factor determined are input to the weighting D/A converter, whereby D/A conversion of the digital value and weighting in the predistortion are performed simultaneously. This configuration provides a higher-speed correction of the input of the power amplifier in the predistortion.

In the above embodiment, the power-amplification-characteristic compensation data table for use in compensating the nonlinear characteristic of the power amplifier upon expanding the saturation point of the power amplifier is subjected to rewriting depending on the error between the input data upon setting the power of the power amplifier at a power exceeding the rated power and the data obtained by demodulating the OFDM-modulated wave corresponding to the input data. Due to this configuration, the compensation value upon expanding the saturation point of the power amplifier can be acquired by determining the value of the power-amplification-characteristic compensation data table so that the error assumes a minimum.

In the above embodiment, when the power of the power amplifier is reduced, the power of the power amplifier is reduced at a rate within the response speed of the gain control in a receiving device for receiving the OFDM-modulated wave. Due to this configuration, an influence on the receiving side by the power change of the power amplifier is suppressed to a minimum.

While the invention has been particularly shown and described with reference to exemplary embodiments, the invention is not limited to these embodiments and modifications. It will be understood by those of ordinary skill in the art that various changes may be made therein without departing from the scope of the present invention as defined in the claims.

This application is based upon and claims the benefit of priority from Japanese patent application No. 2007-058565 filed on March 8, 2007.

## Claims

1. An orthogonal-frequency-division-multiplex-modulated-wave, OFDM-modulated-wave, output unit that uses a predistortion technique, comprising:
an amplitude extraction section that extracts an amplitude of an OFDM-modulated wave based on input data;
a power-amplifier control section that sets a supply power of a power amplifier amplifying the OFDM-modulated wave to exceed a rated power thereof if the amplitude extracted by said amplitude extraction section is larger than a specific amplitude, thereby expanding a saturation point of said power amplifier; and
a compensation-value-selection control section that determines a weighting factor in predistortion of the amplitude based on a first compensation-value data table for compensating a non-linear characteristic of said power amplifier upon expanding the saturation point of said power amplifier, when said power-amplifier control section expands the saturation point of said power amplifier.

2. The OFDM-modulated-wave output unit according to claim 1, wherein said power-amplifier control section increases the power of said power amplifier in a stepwise manner depending on the amplitude extracted by said amplitude extraction section.

3. The OFDM-modulated-wave output unit according to claim 2, wherein said first compensation-value data table includes a plurality of compensation-value data tables corresponding to a plurality of supply powers of said power amplifier, and said compensation-value-selection control section selects one of said compensation-value data tables corresponding to one of said power supplies determined by said power-amplifier control section.

4. The OFDM-modulated-wave output unit according to any one of claims 1 to 3, further comprising a weighting D/A converter that receives a digital value obtained by inverse Fourier transform of the input data and the weighting factor determined by said compensation-value-selection control section, to perform simultaneous D/A conversion of the digital value and weighting in the predistortion.

5. The OFDM-modulated-wave output unit according to any one of claims 1 to 4, wherein said compensation-value-selection control section determines said weighting factor in the predistortion based on a second compensation-value data table for compensating the nonlinear characteristic of said power amplifier in a normal state, if said extracted amplitude is below said specific amplitude.

6. The OFDM-modulated-wave output unit according to any one of claims 1 to 5, further comprising a control section that rewrites said first compensation-value data table based on an error between specific input data upon setting the supply power of said power amplifier to exceed said rated power and data obtained by demodulating the OFDM-modulated wave corresponding to specific input data.

7. The OFDM-modulated-wave output unit according to any one of claims 1 to 6, further comprising a continued-peak control section that detects a continued peak in the OFDM-modulated wave, and gradually reduces the power of said power amplifier.

8. The OFDM-modulated-wave output unit according to claim 7, wherein said continued-peak control section reduces the power of said power amplifier at a rate within a response speed of gain control of a receiving device for receiving the OFDM-modulated wave.

9. A distortion compensating method in an orthogonal-frequency-division-multiplex, OFDM, transmission system using a predistortion technique, comprising:
extracting an amplitude of an OFDM-modulated wave based on input data;
setting a supply power of a power amplifier amplifying the OFDM-modulated wave to exceed a rated power thereof if the extracted amplitude is larger than a specific amplitude, thereby expanding a saturation point of said power amplifier; and
determining a weighting factor in predistortion of the amplitude based on a first compensation-value data table for compensating a non-linear characteristic of said power amplifier upon expanding the saturation point of said power amplifier.

10. The distortion compensating method according to claim 9, wherein said setting of the power of said power amplifier to exceed the rated power of said power amplifier increases the power of said power amplifier in a stepwise manner depending on the extracted amplitude.

11. The distortion compensating method according to claim 10, wherein said first compensation-value data table includes a plurality of tables corresponding to a plurality of supply powers of said power amplifier, and one of said tables corresponding to a power set in said power amplifier is selected.

12. The distortion compensating method according to any one of claims 9 to 11, comprising receiving a digital value obtained by inverse Fourier transform of the input data and the weighting factor determined in a weighting D/A converter, and performing simultaneous D/A conversion of the digital value and weighting in the predistortion.

13. The distortion compensating method according to any one of claims 9 to 12, comprising selecting a second compensation-value data table for compensating the nonlinear characteristic of said power amplifier in a normal state, if said extracted amplitude is below said specific amplitude.

14. The distortion compensating method according to any one of claims 9 to 13, comprising rewriting said second compensation-value data table based on an error between specific input data upon setting the supply power of said power amplifier to exceed said rated power and data obtained by demodulating the OFDM-modulated wave corresponding to specific input data.

15. The distortion compensating method according to any one of claims 9 to 14, comprising detecting a continued peak in the OFDM-modulated wave, to gradually reduce the power of said power amplifier.

16. The distortion compensating method according to claim 15, wherein said reduction of the power of said power amplifier reduces the power of aid power amplifier at a rate within a response speed of gain control of a receiving device for receiving the OFDM-modulated wave.

## Patentansprüche

1. Einheit zur Ausgabe Orthogonalfrequenzmultiplex-modulierter Wellen, OFDMmodulierter Wellen, die ein Vorverzerrungsverfahren anwendet, umfassend:
einen Amplitudenextraktionsabschnitt, der eine Amplitude einer OFDM-modulierten Welle basierend auf Eingangsdaten extrahiert;
einen Leistungsverstärker-Steuerabschnitt, der eine Versorgungsleistung eines Leistungsverstärkers einstellt, der die OFDM-modulierte Welle verstärkt, um eine Nennleistung davon zu übersteigen, wenn die von dem Amplitudenextraktionsabschnitt extrahierte Amplitude größer ist als eine bestimmte Amplitude, wodurch ein Sättigungspunkt des Leistungsverstärkers expandiert wird; und
einen Kompensationswertauswahlsteuerabschnitt, der einen Wichtungsfaktor der Vorverzerrung der Amplitude basierend auf einer ersten Kompensationswertdatentabelle zum Kompensieren einer nichtlinearen Kennlinie des Leistungsverstärkers nach dem Expandieren des Sättigungspunktes des Leistungsverstärkers bestimmt, wenn der Leistungsverstärkersteuerabschnitt den Sättigungspunkt des Leistungsverstärkers expandiert.

2. Einheit zur Ausgabe OFDM-modulierter Wellen nach Anspruch 1, wobei der Leistungsverstärkersteuerabschnitt die Leistung des Leistungsverstärkers abhängig von der Amplitude, die von dem Amplitudenextraktionsabschnitt extrahiert wird, schrittweise erhöht.

3. Einheit zur Ausgabe OFDM-modulierter Wellen nach Anspruch 2, wobei die erste Kompensationswertdatentabelle eine Mehrzahl Kompensationswertdatentabellen entsprechend einer Mehrzahl Versorgungsleistungen des Leistungsverstärkers umfasst und der Kompensationswertauswahlsteuerabschnitt eine der Kompensationswertdatentabellen entsprechend einer der Leistungsversorgungen, die durch den Leistungsverstärkersteuerabschnitt bestimmt wird, auswählt.

4. Einheit zur Ausgabe OFDM-modulierter Wellen nach einem der Ansprüche 1 bis 3, weiterhin umfassend einen wichtenden D/A-Wandler, der einen durch inverse Fouriertransformation der Eingangsdaten erhaltenen digitalen Wert und den von dem Kompensationswertauswahlsteuerabschnitt bestimmten Wichtungsfaktor empfängt, um gleichzeitige D/A-Wandlung des digitalen Werts und Wichten in der Vorverzerrung auszuführen.

5. Einheit zur Ausgabe OFDM-modulierter Wellen nach einem der Ansprüche 1 bis 4, wobei der Kompensationswertauswahlsteuerabschnitt den Wichtungsfaktor in der Vorverzerrung basierend auf einer zweiten Kompensationswertdatentabelle zum Kompensieren der nichtlinearen Kennlinie des Leistungsverstärkers in einem normalen Zustand bestimmt, wenn die extrahierte Amplitude unter der bestimmten Amplitude liegt.

6. Einheit zur Ausgabe OFDM-modulierter Wellen nach einem der Ansprüche 1 bis 5, weiterhin umfassend einen Steuerabschnitt, der die erste Kompensationswertdatentabelle basierend auf einem Fehler zwischen bestimmten Eingangsdaten nach Einstellen der Versorgungsleistung des Leistungsverstärkers überschreibt, um die Nennleistung und Daten, die durch Demodulieren der OFDM-modulierten Welle entsprechend bestimmten Eingangsdaten erhalten werden, zu übersteigen.

7. Einheit zur Ausgabe OFDM-modulierter Wellen nach einem der Ansprüche 1 bis 6, weiterhin umfassend einen Dauerspitzensteuerabschnitt, der eine andauernde Spitze in der OFDM-modulierten Welle erkennt und die Leistung des Leistungsverstärkers allmählich verringert.

8. Einheit zur Ausgabe OFDM-modulierter Wellen nach Anspruch 7, wobei der Dauerspitzensteuerabschnitt die Leistung des Leistungsverstärkers mit einer Rate innerhalb einer Antwortgeschwindigkeit der Verstärkungssteuerung einer Empfangseinrichtung zum Empfangen der OFDM-modulierten Welle verringert.

9. Verzerrungskompensationsverfahren in einem Orthogonalfrequenzmultiplex(OFDM)-Übermittlungssystem unter Verwendung eines Vorverzerrungsverfahrens, umfassend:
Extrahieren einer Amplitude einer OFDM-modulierten Welle basierend auf Eingangsdaten;
Einstellen einer Versorgungsleistung eines Leistungsverstärkers, der die OFDM-modulierte Welle verstärkt, um eine Nennleistung davon zu übersteigen, wenn die extrahierte Amplitude größer ist als eine bestimmte Amplitude, wodurch ein Sättigungspunkt des Leistungsverstärkers expandiert wird; und
Bestimmen eines Wichtungsfaktors der Vorverzerrung der Amplitude basierend auf einer ersten Kompensationswert-Datentabelle zum Kompensieren einer nichtlinearen Kennlinie des Leistungsverstärkers nach dem Expandieren des Sättigungspunktes des Leistungsverstärkers.

10. Verzerrungskompensationsverfahren nach Anspruch 9, wobei das Einstellen der Leistung des Leistungsverstärkers, um die Nennleistung des Leistungsverstärkers zu übersteigen, die Leistung des Leistungsverstärkers abhängig von der extrahierten Amplitude schrittweise erhöht.

11. Verzerrungskompensationsverfahren nach Anspruch 10, wobei die erste Kompensationswertdatentabelle eine Mehrzahl Tabellen entsprechend einer Mehrzahl Versorgungsleistungen des Leistungsverstärkers umfasst und eine der Tabellen ausgewählt wird, die einer Leistung entspricht, die in dem Leistungsverstärker eingestellt ist.

12. Verzerrungskompensationsverfahren nach einem der Ansprüche 9 bis 11, umfassend das Empfangen eines digitalen Werts, der durch inverse Fouriertransformation der Eingangsdaten erhalten wird, und des in einem wichtenden D/A-Wandler bestimmten Wichtungsfaktors, und Durchführen von gleichzeitiger D/A-Wandlung des digitalen Werts und von Wichten in der Vorverzerrung.

13. Verzerrungskompensationsverfahren nach einem der Ansprüche 9 bis 12, umfassend das Auswählen einer zweiten Kompensationswertdatentabelle zum Kompensieren der nichtlinearen Kennlinie des Leistungsverstärkers in einem normalen Zustand, wenn die extrahierte Amplitude unter der bestimmten Amplitude liegt.

14. Verzerrungskompensationsverfahren nach einem der Ansprüche 9 bis 13, umfassend das Überschreiben der zweiten Kompensationswertdatentabelle basierend auf einem Fehler zwischen bestimmten Eingangsdaten nach Einstellen der Versorgungsleistung des Leistungsverstärkers, um die Nennleistung und Daten, die durch Demodulieren der OFDM-modulierten Welle entsprechend bestimmten Eingangsdaten erhalten werden, zu übersteigen.

15. Verzerrungskompensationsverfahren nach einem der Ansprüche 9 bis 14, umfassend das Erkennen einer andauernden Spitze in der OFDM-modulierten Welle, um die Leistung des Leistungsverstärkers allmählich zu verringern.

16. Verzerrungskompensationsverfahren nach Anspruch 15, wobei die Verringerung der Leistung des Leistungsverstärkers die Leistung des Hilfsleistungsverstärkers mit einer Rate innerhalb einer Antwortgeschwindigkeit der Verstärkungssteuerung einer Empfangseinrichtung zum Empfangen der OFDM-modulierten Welle verringert.

## Revendications

1. Unité de sortie à onde modulée à multiplexage par répartition en fréquences orthogonales, onde modulée OFDM, qui utilise une technique de prédistorsion, qui comprend :
une section d'extraction d'amplitude qui extrait une amplitude d'une onde modulée OFDM sur la base de données d'entrée ;
une section de commande d'amplificateur de puissance qui définit une puissance d'alimentation d'un amplificateur de puissance qui amplifie l'onde modulée OFDM afin de dépasser une puissance nominale de celui-ci si l'amplitude extraite par ladite section d'extraction d'amplitude est supérieure à une amplitude spécifique, ce qui permet d'étendre un point de saturation dudit amplificateur de puissance ; et
une section de commande de sélection de valeur de compensation qui détermine un facteur de pondération dans la pré-distorsion de l'amplitude sur la base d'une première table de données de valeurs de compensation afin de compenser une caractéristique non linéaire dudit amplificateur de puissance lors de l'extension du point de saturation dudit amplificateur de puissance, lorsque ladite section de commande d'amplificateur de puissance étend le point de saturation dudit amplificateur de puissance.

2. Unité de sortie à onde modulée OFDM selon la revendication 1, dans laquelle ladite section de commande d'amplificateur de puissance augmente progressivement la puissance dudit amplificateur de puissance selon l'amplitude extraite par ladite section d'extraction d'amplitude.

3. Unité de sortie à onde modulée OFDM selon la revendication 2, dans laquelle ladite première table de données de valeurs de compensation comprend une pluralité de tables de données de valeurs de compensation qui correspond à une pluralité de puissances d'alimentation dudit amplificateur de puissance, et ladite section de commande de sélection de valeur de compensation sélectionne l'une desdites tables de données de valeurs de compensation qui correspond à l'une desdites puissances d'alimentation déterminées par ladite section de commande d'amplificateur de puissance.

4. Unité de sortie à onde modulée OFDM selon l'une quelconque des revendications 1 à 3, qui comprend en outre un convertisseur N/A de pondération qui reçoit une valeur numérique obtenue par transformée de Fourier inverse des données d'entrée et le facteur de pondération déterminé par ladite section de commande de sélection de valeur de compensation, afin d'effectuer une conversion N/A simultanée de la valeur numérique et une pondération au sein de la pré-distorsion.

5. Unité de sortie à onde modulée OFDM selon l'une quelconque des revendications 1 à 4, dans laquelle ladite section de commande de sélection de valeur de compensation détermine ledit facteur de pondération au sein de la pré-distorsion sur la base d'une seconde table de données de valeurs de compensation afin de compenser la caractéristique non linéaire dudit amplificateur de puissance dans un état normal, si ladite amplitude extraite est inférieure à ladite amplitude spécifique.

6. Unité de sortie à onde modulée OFDM selon l'une quelconque des revendications 1 à 5, qui comprend en outre une section de commande qui réécrit ladite première table de données de valeurs de compensation sur la base d'une erreur entre des données d'entrée spécifiques lors de la définition de la puissance d'alimentation dudit amplificateur de puissance comme dépassant ladite puissance nominale et des données obtenues en démodulant l'onde modulée OFDM, qui correspondent à des données d'entrée spécifiques.

7. Unité de sortie à onde modulée OFDM selon l'une quelconque des revendications 1 à 6, qui comprend en outre une section de commande à pic continu qui détecte un pic continu au sein de l'onde modulée OFDM, et réduit progressivement la puissance dudit amplificateur de puissance.

8. Unité de sortie à onde modulée OFDM selon la revendication 7, dans laquelle ladite section de commande à pic continu réduit la puissance dudit amplificateur de puissance à une vitesse qui se trouve dans les limites d'une vitesse de réponse de la commande de gain d'un dispositif de réception destiné à recevoir l'onde modulée OFDM.

9. Procédé de compensation de la distorsion dans un système de transmission à multiplexage par répartition en fréquences orthogonales, OFDM, qui utilise une technique de pré-distorsion, qui comprend :
l'extraction d'une amplitude d'une onde modulée OFDM sur la base de données d'entrée ;
la définition d'une puissance d'alimentation d'un amplificateur de puissance qui amplifie l'onde modulée OFDM afin de dépasser une puissance nominale de celui-ci si l'amplitude extraite est supérieure à une amplitude spécifique, ce qui permet d'étendre un point de saturation dudit amplificateur de puissance ; et
la détermination d'un facteur de pondération dans la pré-distorsion de l'amplitude sur la base d'une première table de données de valeurs de compensation afin de compenser une caractéristique non linéaire dudit amplificateur de puissance lors de l'extension du point de saturation dudit amplificateur de puissance.

10. Procédé de compensation de la distorsion selon la revendication 9, dans lequel ladite définition de la puissance dudit amplificateur de puissance comme dépassant la puissance nominale dudit amplificateur de puissance fait progressivement augmenter la puissance dudit amplificateur de puissance selon l'amplitude extraite.

11. Procédé de compensation de la distorsion selon la revendication 10, dans lequel ladite première table de données de valeurs de compensation comprend une pluralité de tables qui correspond à une pluralité de puissances d'alimentation dudit amplificateur de puissance, et l'une desdites tables qui correspond à une puissance définie dans ledit amplificateur de puissance est sélectionnée.

12. Procédé de compensation de la distorsion selon l'une quelconque des revendications 9 à 11, qui comprend la réception d'une valeur numérique obtenue par transformée de Fourier inverse des données d'entrée et le facteur de pondération déterminé dans un convertisseur N/A de pondération, et la réalisation d'une conversion N/A simultanée de la valeur numérique et d'une pondération au sein de la pré-distorsion.

13. Procédé de compensation de la distorsion selon l'une quelconque des revendications 9 à 12, qui comprend la sélection d'une seconde table de données de valeurs de compensation afin de compenser la caractéristique non linéaire dudit amplificateur de puissance dans un état normal, si ladite amplitude extraite est inférieure à ladite amplitude spécifique.

14. Procédé de compensation de la distorsion selon l'une quelconque des revendications 9 à 13, qui comprend la réécriture de ladite seconde table de données de valeurs de compensation sur la base d'une erreur entre des données d'entrée spécifiques lors de la définition de la puissance d'alimentation dudit amplificateur de puissance comme dépassant ladite puissance nominale et des données obtenues en démodulant l'onde modulée OFDM, qui correspondent à des données d'entrée spécifiques.

15. Procédé de compensation de la distorsion selon l'une quelconque des revendications 9 à 14, qui comprend la détection d'un pic continu au sein de l'onde modulée OFDM, et réduit progressivement la puissance dudit amplificateur de puissance.

16. Procédé de compensation de la distorsion selon la revendication 15, dans lequel ladite réduction de la puissance dudit amplificateur de puissance réduit la puissance dudit amplificateur de puissance à une vitesse qui se trouve dans les limites d'une vitesse de réponse de la commande de gain d'un dispositif de réception destiné à recevoir l'onde modulée OFDM.
